Europäisches Patentamt

European Patent Office

Office européen des brevets

(19)

(11) Publication number: **0 048 638**
**A2**

# EUROPEAN PATENT APPLICATION

(21) Application number: **81304435.1**

(22) Date of filing: **25.09.81**

(51) Int. Cl.³: **H 03 K 5/153**

(30) Priority: **26.09.80 US 191117**

(43) Date of publication of application:
**31.03.82 Bulletin 82/13**

(84) Designated Contracting States:
**BE DE FR GB IT NL**

(71) Applicant: **Honeywell Information Systems Inc.**
**200 Smith Street**
**Waltham Massachusetts 02154(US)**

(72) Inventor: **Nowell, John R.**
**2101 West Anderson Ave.**
**Phoenix Arizona 85023(US)**

(74) Representative: **Harman, Michael Godfrey et al,**
**Honeywell Control Systems Ltd. Patent Department**
**Charles Square**
**Bracknell Berks RG12 1EB(GB)**

(54) **Maximum frequency limiter.**

(57) The circuit limits the frequency of pulses passing through it (from input 62 to output 66) by deleting any input pulse which follows too closely on the preceding pulse. A counter 116 counts clock pulses from 110, and stops at count 15. An input pulse sets flip-flop 118, which resets flip-flop 114, which allows counter 116 to cycle back to 0 and produce an output pulse. The output pulse resets flip-flop 118, which flip-flop 114, so the counter 116 stops again at count 15 awaiting the next input pulse. The output pulses cannot occur at intervals less than 16 times the period of the clock pulses.

## FREQUENCY LIMITER

The present invention relates to frequency limiters which prevent a stream of pulses passing through them from exceeding a predetermined frequency at their output.

Such a circuit finds particular application in a power supply circuit of the type having a switching regulator unit including SCR's which are repeatedly fired to produce a regulated DC output, a voltage controlled oscillator which is fed with a voltage feedback signal from the regulated output, and an SCR sequencer unit which fires the SCR's in the switching regulator unit in a predetermined sequence in response to the pulses from the voltage controlled oscillator. If the frequency of the pulses from the oscillator rises too high, the SCR's may be fired at a rate which results in their refiring before they have fully recovered from the previous firing, and this can easily be disastrous to the SCR's. By including a frequency limiter between the oscillator and the SCR sequencer unit, the pulse frequency to the SCR sequencer unit, and hence to the SCR's themselves, can be limited to a safe frequency.

According to the present invention there is provided a frequency limiter for preventing the frequency of a pulse stream passing therethrough from exceeding a predetermined limit, characterized by a clock oscillator feeding a counter, and a logic network responsive to an input signal to reset the counter provided it is at its maximum count, an output signal being generated on each cycle of the counter.

It will therefore be seen that the counter does not automatically cycle back to 0 (reset state), but is reset in response to an input signal. The output signal can be generated on the counter reaching its maximum count, but this results in the output signal being delayed from the input signal by the count time of the counter. The output signal is therefore preferably generated by the resetting of the counter i.e. without appreciable delay from the input signal.

It will be realized that the circuit simply deleted from the output pulse stream any input pulse which follows an output pulse too closely.

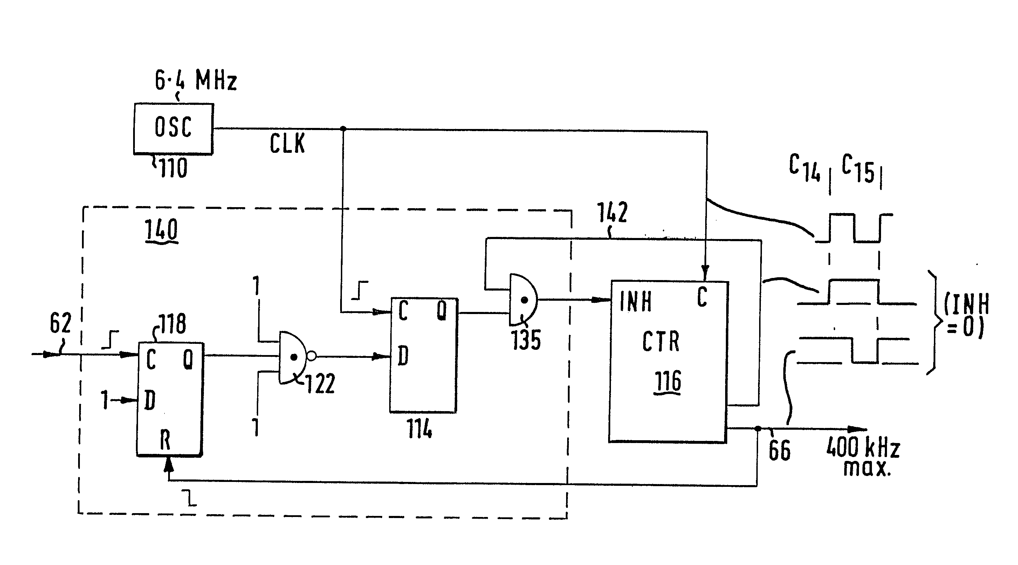

A frequency limiter in accordance with the invention will now be described, by way of example, with reference to the the accompanying drawing, which is a block diagram of the limiter.

Input pulses of frequency up to 400 kHz are fed on line 62 to a logic network 140. A clock oscillator 110 generates a stream of clock pulses of frequency 6.4 MHz which are fed to the logic network 140 and to the clock input of a scale-of-16 counter 116. The counter 116 produces output pulses on line 66, and is coupled to the logic network 140 as shown. The logic network 140 comprises two flip-flops 118 and 114, a NAND gate 122, and an AND gate 135.

In general terms, the circuit operates as follows. The counter 116 counts up to its maximum count of 15, at which count it produces an output on line 142 which enables gate 135 and puts a 1 on the inhibit input INH of the counter, which is thereupon frozen at count 15. The counter 116 by itself is a cyclic counter, but the feedback loop from its output 142 to its inhibit input INH converts it to a non-cyclic counter, which simply counts up to its maximum count of 15 and then remains at that count until it is in effect reset by the other input to gate 135 going to 0. An input pulse on line 62 sets flip-flop 118, which in turn resets flip-flop 114, sending its Q output to O and removing the inhibit signal to counter 116. The counter thereupon produces an output pulse on line 66 and continues to count, cycling back immediately to O and counting upwards again towards 15. The output pulse on line 66 also resets flip-flop 118.

It can therefore be seen that counter 116 has to complete a full cycle between two successive output pulses. After each output pulse, another input pulse can be registered by the setting of a flip-flop 118, but if an input pulse arrives before counter 116 has completed a full cycle, flip-flop 118 will not have been reset and that input pulse will have no effect.

In more detail, counter 116 produces an output pulse on line 142 as shown at count 15, rising and falling on successive rising edges of the clock signal. The output on line 66 is normally at 1, and falls to O only on the falling edge of the clock signal at count 15. (This pulse can be used directly by the circuitry to which it is fed if that circuitry is edge-triggered; if this circuitry requires a narrow pulse, the output of line 66 can be inverted.) The counter outputs are however modified by the inhibit input INH going to 1; this freezes the counter state immediately following the rise of the clock signal, so that the counter does not cycle back to O and that output of line 142 will remain 1 as long as the INH input is 1, but the output on line 66 will not fall to O until the INH input goes to O.

The flip-flop 118 has the input pulses on line 62 fed to its clock input, and has a steady 1 feed to its data input, so it is set to 1 (Q output = 1) on the rising edge of an input pulse on line 62. Its reset input is fed from line 66, a falling edge at its reset input resetting it (to send its Q output to O).

Flip-flop 118 feeds the data input of flip-flop 114 from its Q output via a NAND gate 122. This gate effects an inversion.

In addition, it can be used to control the entire circuit, since it will pass the signals from flip-flop 118 if its other inputs are at 1, but if any of its other inputs go to O, the output of gate 122 goes to a steady 1 and no further pulses can pass through the frequency limiter. The clock input of flip-flop 114 is fed with the clock signals from clock oscillator 110, and flip-flop 114 takes up the state of its D input on the rising edge of a clock signal.

It is therefore evident that the frequency of the output pulses is limited to a maximu value of 1/16th of the frequency of the clock oscillator 110, ie. to 400kHz. More specifically, the interval between two successive output pulses cannot be less than 16 cycles of the clock oscillator.

- 5 -

## CLAIMS

1.  A frequency limiter for preventing the frequency of a pulse stream passing therethrough from exceeding a predetermined limit, characterized by a clock oscillator (110) feeding a counter (116), and a logic network (140) responsive to an input signal (at 62) to reset the counter provided it is at its maximum count, an output signal (at 66) being generated on each cycle of the counter.

2.  A frequency limiter according to claim 1, characterized in that the output signal is taken from the output of the counter.

3.  A frequency limiter according to either previous claim, characterized in that the counter is constructed of a cyclic counter whose output(142) is fed back to an inhibit input (INH) via an AND gate (135).

4.  A frequency limiter according to any previous claim characterized in that the logic network includes a flip-flop (118) which is set by the input signal and reset by the output of the counter.

5.  A frequency limiter according to claim 4 characterized in that the logic network includes a second flip-flop (114) fed by the first flip-flop (118), controlling the resetting of the counter, and clocked by the clock oscillator.

6·4 MHz

OSC
110

CLK

140

1

122

62

118
C   Q
D
R

114
C   Q
D

135

142

INH   C

CTR

116

$C_{14}$ | $C_{15}$ |

(INH =0)

66   400 kHz
max.

1/1

0048638